# EUROPEAN PATENT APPLICATION

(11) **EP 2 418 665 A2**
(43) Date of publication of application: **15.02.2012**
(21) Application number: 11172204.7
(22) Date of filing: 30.06.2011
(51) Int. Cl.: H01G 9/20

(54) **Electrode for photoelectric device, method of preparing the same and photoelectric device comprising the same**

(30) Priority: 11.08.2010 KR 20100077307
(71) Applicant: Samsung SDI Co., Ltd., Yongin-si, Gyeonggi-do (KR)
(72) Inventor: Yang, Nam-Choul, Gyeonggi-do (KR); Hur, Sang-Yeol, Gyeonggi-do (KR)
(74) Representative: Walaski, Jan Filip

(57) **Abstract**

An electrode for a photoelectric device, a method of preparing the same and a photoelectric device including the same. In one embodiment, an electrode for a photoelectric device includes a transparent conductive layer, a metal electrode layer and an intermediate electrode layer. The transparent conductive layer is formed on a substrate. The metal electrode layer is disposed on the transparent conductive layer to have a pattern. The intermediate electrode layer is interposed between the transparent conductive layer and the metal electrode layer to join the transparent conductive layer and the metal electrode layer. Accordingly, the photoelectric device is enhanced.

## Description

The present invention relates to an electrode for a photoelectric device, a method of preparing the same and a photoelectric device including the same.

Solar cells are desired sources of energy because solar energy is virtually unlimited and eco-friendly unlike other comparable energy sources. Solar cells are classified into silicon solar cells, dye solar cells, etc.

Silicon solar cells are difficult to be put to practical use because their fabrication costs are relatively high. Further, it is very difficult to improve the efficiency of the silicon solar cells.

On the other hand, dye solar cells are photoelectric chemical solar cells using a dye molecule and a transition metal oxide as their main material components. Here, the dye molecule generates electron-hole pairs by absorbing visible light, and the transition metal oxide transfers the generated electrons. Since the dye solar cells have remarkably lower fabrication costs than existing silicon-based solar cells, they may replace conventional amorphous silicon solar cells.

A method of printing silver paste and then drying and sintering the printed silver paste is frequently used as a method of forming an electrode for a dye solar cell. In the silver paste, silver powder, binder, organic solvent and the like are mixed together.

However, silver (Ag) is a high-priced precious metal. When the silver paste is kept for a long period of time, the phase separation of the silver paste occurs, and therefore, has influence on properties of a film formed with the silver paste. Also, since a difference in viscosity and rheological properties occurs due to the continuous volatilization of the organic solvent in the printing process, the properties of the film are not constant.

In addition, since the method includes printing, drying and sintering processes, process time is increased, and there are other additional process costs, such as cost for replacing a silk screen mask and a squeegee, cost for performing a grinding process, and cost for maintaining drying and sintering furnaces, which are additionally consumed in the printing and sintering processes.

Aspects of embodiments of the present invention are directed toward an electrode for a photoelectric device, a method of preparing the same and a photoelectric device including the same, which can enhance price competitiveness and simplify preparing processes by replacing a conventional electrode material.

According to an embodiment of the present invention, there is provided an electrode for a photoelectric device, the electrode including: a transparent conductive layer formed on a substrate; a metal electrode layer disposed on the transparent conductive layer to have a pattern; and an intermediate electrode layer interposed between the transparent conductive layer and the metal electrode layer to join the transparent conductive layer and the metal electrode layer.

The intermediate electrode layer may include a material selected from the group consisting of Ti, Cr, Ni, Nb, Mo, Sn, Ta, W, Pt, Au, sus (stainless steel), ITO, FTO, ZnO, SnO(II), SnO₂(IV) and combinations thereof.

The intermediate electrode layer may have a thickness between 0.01µm and 10µm.

The intermediate electrode layer may have a pattern matching the pattern of the metal electrode layer.

The metal electrode layer may include a material selected from the group consisting of Al, Ni, Cu, Zn, Mo, Ag, Pt, Au and combinations thereof.

The metal electrode layer may have a thickness between 0.1µm and 100µm.

According to an embodiment of the present invention, there is provided a method of preparing an electrode for a photoelectric device, the method including: providing a substrate having a transparent conductive layer formed thereon; forming an intermediate electrode layer having to have a pattern on the transparent conductive layer; and forming a metal electrode layer on the intermediate electrode layer so that the metal electrode layer is joined with the intermediate electrode layer.

The forming of the intermediate electrode layer may include disposing a first mask having openings respectively matching portions of the transparent conductive layer; and depositing an intermediate electrode forming material on the transparent conductive layer through the openings.

The intermediate electrode forming material may include a material selected from the group consisting of Ti, Cr, Ni, Nb, Mo, Sn, Ta, W, Pt, Au, sus, ITO, FTO, ZnO, SnO(II), SnO2(IV) and combinations thereof.

The intermediate electrode forming material may be deposited to have a thickness between 0.01 µm and 10 µm.

The forming of the intermediate electrode layer and the metal electrode layer may include depositing an intermediate electrode forming material on the transparent conductive layer, thereby forming a preliminary intermediate electrode layer; depositing a metal electrode forming material on the intermediate electrode forming material, thereby forming a preliminary metal electrode layer; and etching the preliminary intermediate electrode layer and the preliminary metal electrode layer.

According to an embodiment of the present invention, there is provided a photoelectric device including: a first electrode formed on a first substrate; a photoelectrode layer formed on at least one surface of the first electrode, the photoelectrode layer including a photo-sensitizing dye; a second electrode formed on a second substrate and facing the first electrode; a counter-electrode layer formed on at least one surface of the second electrode, the counter-electrode layer including a conductive catalyst; and a sealing member joining the first and second electrodes and an electrolyte solution injected into a space between the first and second electrodes and sealed in the space between the first and second electrode by the sealing member, wherein at least one of the first and second electrodes includes a transparent conductive layer formed on a corresponding one of the first and second substrates, a metal electrode layer disposed on the transparent conductive layer to have a pattern, and an intermediate electrode layer interposed between the transparent conductive layer and the metal electrode layer to join the transparent conductive layer and the metal electrode layer.

As described above, according to the embodiments of the present invention, the price competitiveness of the photoelectric device can be enhanced by replacing a conventional electrode material.

Also, the adhesion between the metal electrode layer and the transparent conductive layer is increased due to the intermediate electrode layer interposed between the transparent conductive layer and the metal electrode layer, so that it is possible to prevent (or protect from) a phenomenon in which the electrolyte solution is penetrated into the interface between the transparent conductive layer and the metal electrode layer, and therefore, the metal electrode layer gets loose. Accordingly, it is possible to increase the photoelectric conversion efficiency of the photoelectric device and to enhance the reliability of the photoelectric device.

The accompanying drawings, together with the specification, illustrate exemplary embodiments of the present invention, and, together with the description, serve to explain the principles of the present invention.
FIG. 1 is a sectional view schematically showing the entire configuration of a photoelectric device according to an embodiment of the present invention.
FIG. 2 is a view schematically showing the state in which a dye is connected to an inorganic metal oxide semiconductor.
FIG. 3 is a sectional view schematically showing the structure of an electrode for the photoelectric device according to the embodiment of the present invention.
FIG. 4 is a scanning electron microscope (SEM) image showing the structure of the electrode for the photoelectric device according to the embodiment of the present invention.
FIGS. 5A to 5E are sectional views schematically showing processes of preparing an electrode for the photoelectric device according to a first embodiment of the present invention.
FIGS. 6A to 6D are sectional views schematically showing processes of preparing an electrode for the photoelectric device according to a second embodiment of the present invention.

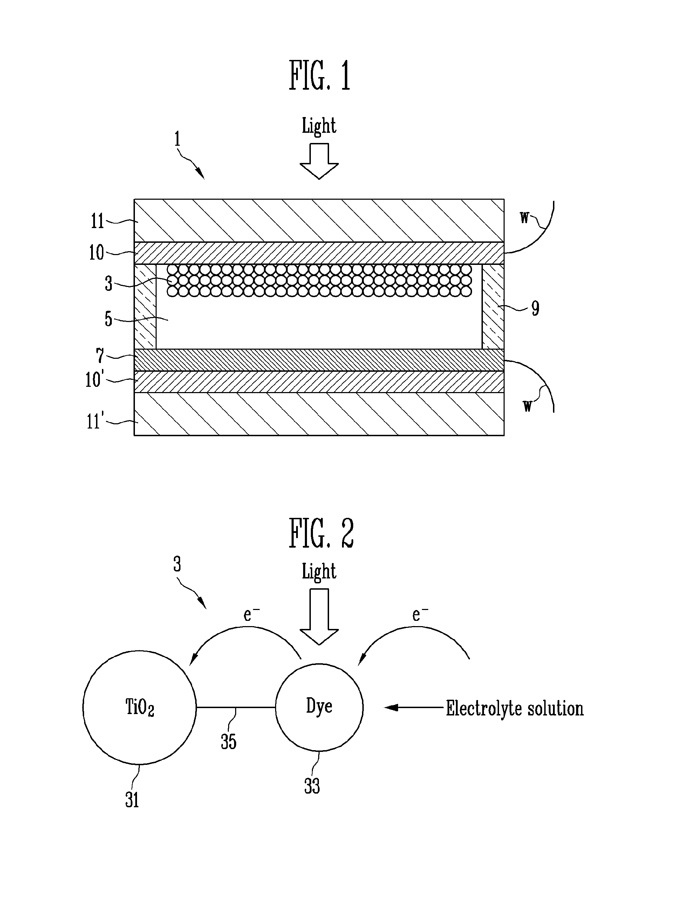

Hereinafter, an electrode for a photoelectric device and a photoelectric device including the same according to an embodiment of the present invention will be described in more detail with reference to FIGS. 1 to 3.

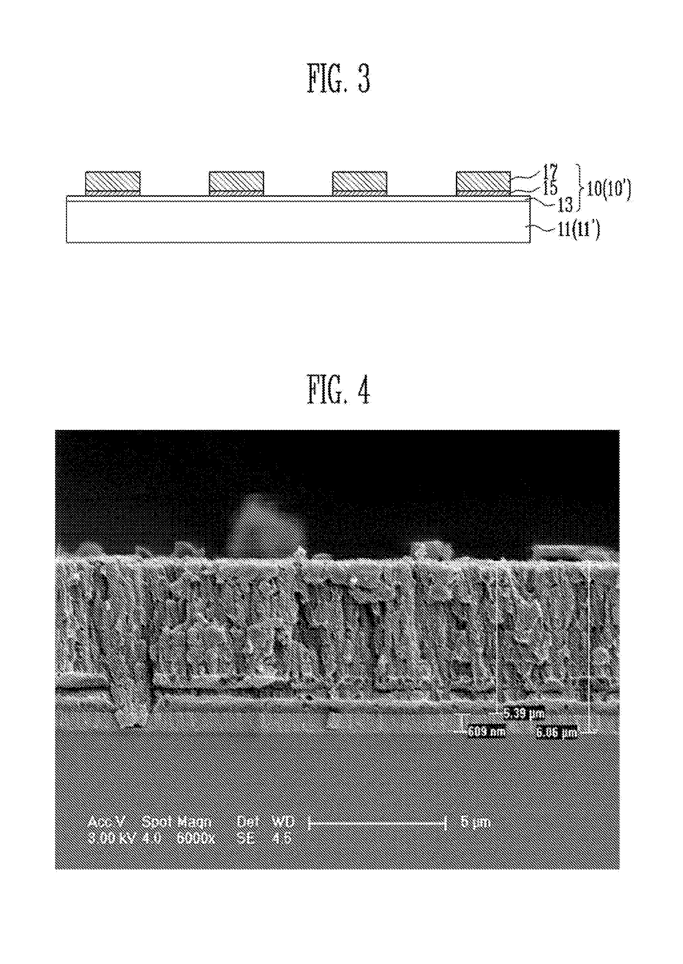

FIG. 1 is a sectional view schematically showing the entire configuration of a photoelectric device according to an embodiment of the present invention. FIG. 2 is a view schematically showing the state in which a dye is connected to an inorganic metal oxide semiconductor. FIG. 3 is a sectional view schematically showing the structure of an electrode for the photoelectric device according to the embodiment of the present invention.

Referring to FIGS. 1 and 2, a photoelectric device 1 according to an embodiment of the present invention includes a first substrate 11, a second substrate 11', a first electrode 10, a second electrode 10', a photoelectrode layer 3, a counter-electrode layer 7, an electrolyte solution 5, a sealing member 9 and extracting wires W.

The first and second substrates 11 and 11' are disposed to face (or to oppose) each other with a set or predetermined interval therebetween. The material of the first and second substrates 11 and 11' can be any suitable transparent material having a low light absorption with respect to a spectrum or range from a visible region to a near infrared region of light (e.g., sunlight or the like) incident on the photoelectric device 1 from the exterior of the photoelectric device 1.

In one embodiment, the material of the first and second substrates 11 and 11' include a glass material such as quartz, general glass, crown glass (borosilicate glass or BK7) or lead glass, a resin material such as polyethylene terephthalate, polyethylene naphthalate, polyimide, polyester, polyethylene, polycarbonate, polyvinylbutyrate, polypropylene, tetraacetylcellulose, syndiotactic polystyrene, polyphenylenesulfide, polyarylate, polysulfone, polyestersulfone, polyetherimide, annular polyolefin, phenoxy bromide or vinyl chloride, or the like.

In the first and second substrates 11 and 11', a transparent conductive layer 13 formed into a film, for example, using a transparent conductive oxide (TCO) is formed on a surface of at least the first substrate 11 onto which external light is incident. The TCO can be any suitable conductive material having a low light absorption with respect to a spectrum or range from a visible region to a near infrared region of light incident from the exterior of the photoelectric device 1. For example, the TCO may be a metal oxide having excellent conductivity, such as indium tin oxide (ITO), tin oxide (SnO₂), fluorine-doped tin oxide (FTO), antimony-doped tin oxide (ATO) or zinc oxide (ZnO₂).

In order to enhance photoelectric conversion efficiency, the surface resistance of the first and second electrodes 10 and 10' should be as low as possible.

However, in the first and second substrates 11 and 11', the second electrode 10' formed on a surface of the second substrate 11' opposite to (or facing away from) the first substrate 11 is not essential. In a case where the second electrode 10' is formed on the surface of the second substrate 11', it is not necessarily transparent. That is, the second electrode 10' does not necessarily have a low absorption with respect to a spectrum or range from a visible region to a near infrared region of light incident from the exterior of the photoelectric device 1.

Also, detailed description of the first or second electrode 10 or 10' according to this embodiment will be described later in more detail.

In the photoelectric device 1, the photoelectrode layer 3 is used as an inorganic metal oxide semiconductor layer having a photoelectric conversion function. The photoelectrode layer 3 is formed as a porous layer.

More specifically, as shown in FIGS. 1 and 2, the photoelectrode layer 3 is formed by stacking a plurality of metal oxide corpuscles 31 such as TiO₂ on the surface of the first electrode 10. The metal oxide corpuscles 31 stacked as described above constitute a porous body, i.e., a nano-porous layer containing nano-meter pores therein.

As described above, the photoelectric layer 3 is formed into a porous body containing a plurality of micro-pores, so that it is possible to increase the surface area of the photoelectrode layer 3 and to connect a large amount of sensitizing dye 33 to the surface of the metal oxide corpuscle 31. Accordingly, the photoelectric device 1 can have high photoelectric conversion efficiency.

In the photoelectrode layer 3, the sensitizing dye 33 is connected to the surface of the metal oxide corpuscle 31 with a linking group 35, thereby obtaining the photoelectrode layer in which inorganic metal oxide semiconductors are sensitized.

The term "linking" refers to the inorganic metal oxide semiconductor and the sensitizing dye being chemically or physically bonded to each other (e.g., bonding by adsorption or the like). Therefore, the term "linking group" includes not only a chemical functional group but also an anchoring or adsorbing group.

Although FIG. 2 shows a state in which only one sensitizing dye molecule 33 is connected on the surface of the metal oxide corpuscle 31, it is only a simple schematic view. In order to increase electrical power of the photoelectric device 1, it is preferable that the number of sensitizing dye molecules 33 connected to the surface of the metal oxide corpuscle 31 is as large as possible, and a large number of sensitizing dye molecules 33 are coated on the surface of the metal oxide corpuscle 31 as widely as possible.

However, in a case where the number of the coated sensitizing dye molecules is increased, excited electrons may be recombined by interaction between neighbouring sensitizing dye molecules 33, and therefore, these electrons may not be extracted as electric energy. Hence, a co-adsorption substance such as deoxycholic acid may be used so that the sensitizing dye molecules 33 can be coated while maintaining an appropriate distance therebetween. In other words, use of the co-adsorption substance mitigates dye aggregation and can therefore improve photoelectric conversion efficiency.

The photoelectrode layer 3 may be formed by stacking the metal oxide corpuscles 31 having a size of about 20 to 100nm as a number-average particle size of a primary particle into a multi-layered structure. The thickness of the photoelectrode layer 3 may be a few µm (preferably, less than 10 µm).

If the thickness of the photoelectrode layer 3 is thinner than a few µm, light that transmits through the photoelectrode layer 3 is increased, and the light excitation of the sensitizing dyes 33 is insufficient. Therefore, effective photoelectric conversion efficiency may not be obtained.

Also, if the thickness of the photoelectrode layer 3 is thicker than a few µm, the distance between the surface of the photoelectrode layer 3 (the surface that comes in contact with the electrolyte solution 5) and the electrical conducting surface (the interface between the photoelectrode layer 3 and the first electrode 10) is lengthened. Therefore, since it is difficult for excited electrons to be effectively transferred to the electrical conducting surface, satisfactory photoelectric conversion efficiency may not be obtained.

Next, the metal oxide corpuscle 31 and the sensitizing dye 33, available for the photoelectrode layer 3 according to an embodiment of the present invention, will be described in more detail.

Generally, the inorganic metal oxide semiconductor has a photoelectric conversion function for light in a partial wavelength region. However, the sensitizing dye 33 is connected to the surface of the metal oxide corpuscle 31, so that photoelectric conversion is possible with respect to light in a spectrum or range from a visible region to a near infrared region.

A compound available for the metal oxide corpuscle 31 is not particularly limited as long as it is a compound that connects the sensitizing dye 33 and has a sensitized photoelectric conversion function. For example, the compound may include titanium oxide, tin oxide, tungsten oxide, zinc oxide, indium oxide, niobium oxide, iron oxide, nickel oxide, cobalt oxide, strontium oxide, tantalum oxide, antimony oxide, lanthanide oxide, yttrium oxide, vanadium oxide, or the like.

Here, since the surface of the metal oxide corpuscle 31 is sensitized by the sensitizing dye 33, the conduction band of the inorganic metal oxide may exist at a position at which it easily receives electrons from the optical excitation trap of the sensitizing dye 33.

In this viewpoint, the compound used as the metal oxide corpuscle 31 may include titanium oxide, tin oxide, zinc oxide, niobium oxide or the like. In the viewpoint of price, environment or the like, the compound used as the metal oxide corpuscle 31 may include titanium oxide.

The sensitizing dye 33 is not particularly limited as long as it is a dye having a photoelectric conversion function with respect to light in a set spectrum or range (e.g., in a spectrum or range from a visible light region to a near infrared light region). For example, the sensitizing dye 33 may include an azo-based dye, a quinacridone-based dye, a diketopyrrolopyrrole-based dye, a squarylium-based dye, a cyanine-based dye, a merocyanine-based dye, a triphenylmethane-based dye, a xanthene-based dye, a porphyrin-based dye, a chlorophyll-based dye, a ruthenium complex-based dye, an indigo-based dye, a perylene-based dye, a dioxadine-based dye, an anthraquinone-based dye, a phthalocyanine-based dye, a naphthalocyanine-based dye, a derivative thereof, or the like.

The sensitizing dye 33 may include a functional group connectable to the surface of the metal oxide corpuscle 31 as the linking group so that excitation electrons of the optically excited dye can be rapidly transferred to the conduction band of the inorganic metal oxide.

The functional group is not particularly limited as long as it is a substituting group having a function that connects the sensitizing dye 33 to the surface of the metal oxide corpuscle 31 and rapidly transfers the excitation electrons of the dye to the conduction band of the inorganic metal oxide. For example, the functional group may include a carboxyl group, a hydroxyl group, a hydroxamic acid group, a sulfinyl group, a phosphonic acid group, a phosphinic acid group, or the like.

The counter-electrode layer 7 serves as a positive electrode of the photoelectric device 1. The counter-electrode layer 7 is formed as a film on the surface of the second substrate 11' with the second electrode 10' formed thereon, opposing or facing the first substrate 11 with the first electrode 10 formed thereon.

That is, the counter-electrode layer 7 is disposed on the surface of the second electrode 10' to be opposite to the photoelectrode layer 3 in a region surrounded by the first electrode 10, the second electrode 10' and the sealing member 9.

A metal catalyst layer having conductivity is disposed on a surface of the counter-electrode layer 7 (a side of the counter-electrode layer 7, opposite to the photoelectrode layer 3).

For example, the conductive material available for the counter-electrode layer 7 may include metal (platinum, gold, silver, copper, aluminium, rhodium, indium or the like), metal oxide (indium tin oxide (ITO)), tin oxide (including tin oxide doped with fluorine or the like), zinc oxide, conductive carbon material, conductive organic material, or the like.

The thickness of the counter-electrode layer 7 is not particularly limited. For example, the thickness of the counter-electrode layer 7 may be between about 5 nm and 10 µm.

Also, the extracting wires W are respectively connected to the counter-electrode layer 7 and the first electrode 10 of the side at which the photoelectrode layer 3 is formed. The extracting wire W from the first electrode 10 and the extracting wire W from the counter-electrode layer 7 are connected to each other at the exterior of the photoelectric device 1.

The first electrode 10 and the counter-electrode layer 7 may be isolated from each other so as to be sealed by the sealing member 9 while being spaced apart from each other.

The sealing member 9 is formed along outer circumferential portions of the first electrode 10 and the counter-electrode layer 7. The sealing member 9 may function to seal a space between the first electrode 10 and the counter-electrode layer 7.

A resin having high sealing performance and corrosion resistance may be used as the sealing member 9. For example, the resin may include thermoplastic resin, photocurable resin, ionomer resin, glass frit, or the like, which are formed in a film shape.

Also, the electrolyte solution 5 is injected into the space between the first electrode 10 and the counter-electrode layer 7 and then sealed by the sealing member 9.

For example, the electrolyte solution 5 includes an electrolyte, a medium and an additive.

Here, the electrolyte may include a redox electrolyte such as an I3-/I- or Br3-/Br-series, or the like. For example, the electrolyte may include a mixture of I2 and iodide (LiI, NaI, KI, CsI, MgI₂, CuI, tetraalkylammonium iodide, pyridinium iodide, imidazolium iodide and the like), a mixture of Br₂ and bromide (LiBr and the like), an organic molten salt compound, and the like. However, the substance used as the electrolyte is not limited thereto.

The aforementioned iodide, bromide or the like may be used singly or in combinations thereof.

Particularly, the electrolyte may include a mixture of I₂ and iodide (e.g., I₂ and LiI), and an electrolyte mixed with pyridinium iodide, imidazolium iodide or the like. However, the electrolyte is not limited thereto.

In the electrolyte solution 5, the concentration of the I2 may be at 0.01 or 0.5 M or between 0.01 and 0.5 M, and any one or both of the iodide and bromide (in the combinations thereof) may be between about 0.1 and 15 M.

The medium used in the electrolyte solution 5 may be a compound capable of realizing excellent ion conductivity. The medium may include a liquid-phase medium, a solid-phase medium or an ionic liquid.

Various suitable kinds of additives may be added into the electrolyte solution 5 so as to enhance the durability of the photoelectric device 1 or electric power.

The thickness of the layer put and sealed in the electrolyte solution 5 is not particularly limited. However, the layer may be formed to have a thickness in which the counter-electrode layer 7 does not come in direct contact with the photoelectrode layer 3 having the adsorbed dye. Specifically, the thickness of the layer may be between about 0.1 and 100 µm.

In the photoelectrode layer 3 including the metal oxide corpuscle 31 and the sensitizing dye 33 connected to the surface of the metal oxide corpuscle 31 with the linking group 35 interposed therebetween, light comes in contact with the sensitizing dye 33 connected to the surface of the metal oxide corpuscle 31 as illustrated in FIG. 2. Then, the sensitizing dye 33 is in an excitation state and emits optically excited electrons. The emitted excitation electrons are transferred to the conduction band of the metal oxide corpuscle 31 through the linking group 35.

The excitation electrons that approach the metal oxide corpuscle 31 are transferred to another metal oxide corpuscle 31 to approach the first electrode 10, and flow out to the exterior of the photoelectric device 1 through the extracting wire W.

Also, the sensitizing dye 33 that is in a state in which electrons are deficient due to the emitted excitation electrons receives electrons supplied from the counter-electrode layer 7 through the electrolyte such as I3-/I- in the electrolyte solution 5, and thus, returns to an electrically neutral state.

Hereinafter, the configuration of an electrode for a photoelectric device according to embodiments of the present invention will be described with reference to FIGS. 1 and 3 to 6D.

Referring to FIG. 3, a first electrode 10, 10' for the photoelectric device 1 according to the embodiment of the present invention includes a transparent conductive layer 13 formed on a first substrate 11, 11'; a metal electrode layer 17 formed on the transparent conductive layer 13 to have a set or predetermined pattern; and an intermediate layer 15 interposed between the transparent conductive layer 13 and the metal electrode layer 17 to join the transparent conductive layer 13 and the metal electrode layer 17.

Here, the intermediate electrode layer 15 is interposed between the transparent conductive layer 13 and the metal electrode layer 17 as described above so that the transparent conductive layer 13 and the metal electrode layer 17 are well joined together.

In order to enhance adhesion, the intermediate electrode layer 15 may include at least one selected from the group consisting of Ti, Cr, Ni, Nb, Mo, Sn, Ta, W, Pt, Au, sus, ITO, FTO, ZnO, SnO(II), and SnO₂(IV) and/or an alloy including at least two selected from the group consisting of Ti, Cr, Ni, Nb, Mo, Sn, Ta, W, Pt, Au, sus, ITO, FTO, ZnO, SnO(II), and SnO₂(IV). The intermediate electrode layer 15 may be formed to have a thickness between about 0.01 µm and 10 µm.

Also, the intermediate electrode layer 15 may have a pattern with the same (or identical) shape as (or matching) the pattern of the metal electrode layer 17. In view of the enhancement of the adhesion between the transparent conductive layer 13 and the metal electrode layer 17, the intermediate electrode 15 may be formed slightly larger than the pattern of the metal electrode layer 17. However, if the intermediate electrode layer 15 is formed larger than that shown in FIG. 3, light incident onto the photoelectric device 1 is screened (or blocked) by the increased area, and therefore, the photoelectric conversion efficiency of the photoelectric device 1 may be decreased.

The metal electrode layer 17 is formed on the intermediate electrode layer 15 formed on the transparent conductive layer 13 to increase the adhesion between the transparent conductive layer 13 and the metal electrode layer 17. The metal electrode layer 17 has a pattern with the same (or identical) shape as (or matching) the pattern of the intermediate electrode layer 15. As described above, the adhesion between the metal electrode layer 17 and the transparent conductive layer 13 is increased due to the intermediate electrode layer 15 interposed between the transparent conductive layer 13 and the metal electrode layer 17, so that it is possible to prevent (or protect from) a phenomenon that the electrolyte solution 5 (see FIG. 1) is penetrated into the interface between the transparent conductive layer 13 and the metal electrode layer 17, and therefore, the metal electrode layer 17 gets loose. Accordingly, it is possible to increase the photoelectric conversion efficiency of the photoelectric device 1 and to enhance the reliability of the photoelectric device 1. Referring to FIG. 4, it can be seen that the metal electrode layer 17 is formed on the intermediate electrode layer 15 that increases the adhesion to having uniform thickness and shape without looseness.

The metal electrode layer 17 may include at least one selected from the group consisting of Al, Ni, Cu, Zn, Mo, Ag, Pt, and Au and/or an alloy including at least two selected from the group consisting of Al, Ni, Cu, Zn, Mo, Ag, Pt, and Au. The metal electrode layer 17 may be formed to have a thickness between about 0.1 µm and 100 µm.

Among the metals available for the metal electrode layer 17, metal such as Al, which can form an oxide film through combination with oxygen at a normal temperature, forms an oxide film at the normal temperature as described above. Since a metal oxide film serves as a protection layer from the electrolyte solution 5 (see FIG. 1), there is an advantage here that a process of forming a protection layer for an electrode can be omitted as compared with a conventional process. Also, since the processes are simplified, the price competitiveness of the photoelectric device 1 can be more enhanced.

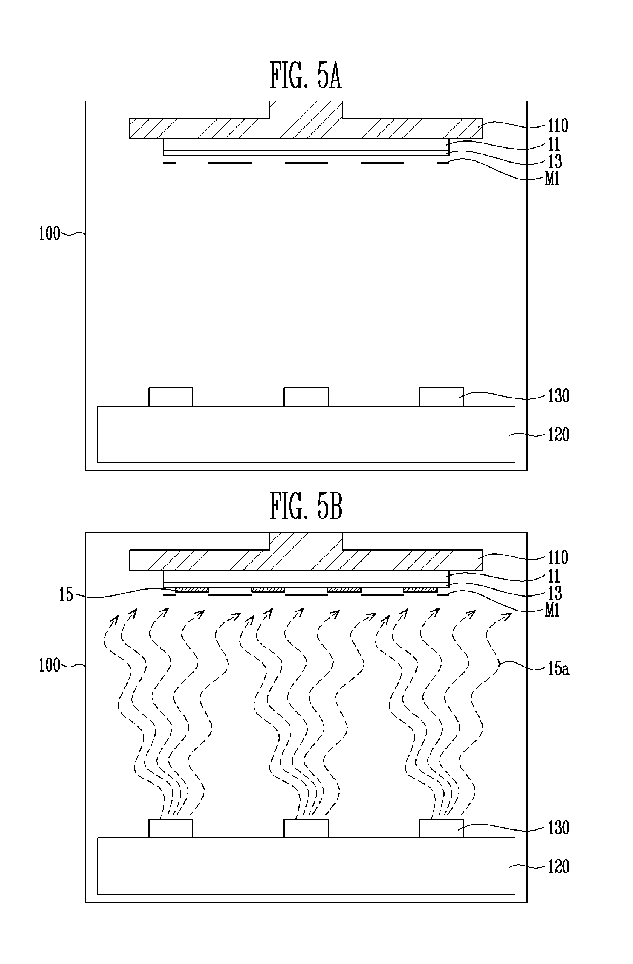

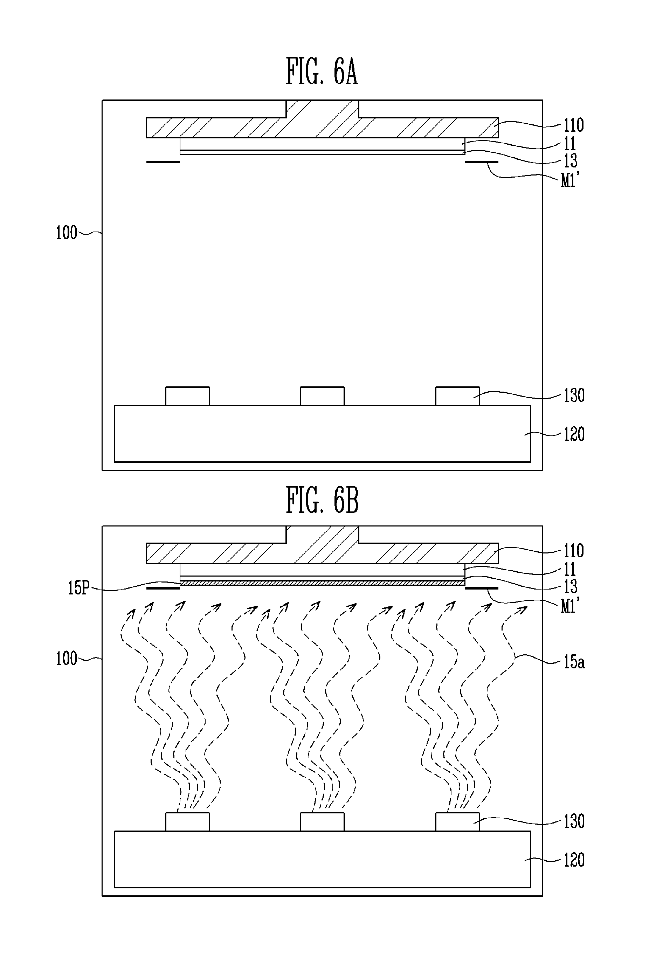

Hereinafter, processes of preparing an electrode for the photoelectric device according to embodiments of the present invention will be described in more detail with reference to FIGS. 5A to 5E and 6A to 6D.

FIGS. 5A to 5E are sectional views schematically showing processes of preparing an electrode for the photoelectric device according to a first embodiment of the present invention. FIGS. 6A to 6D are sectional views schematically showing processes of preparing an electrode for the photoelectric device according to a second embodiment of the present invention.

Hereinafter, the processes of preparing the electrode for the photoelectric device according to the first embodiment of the present invention will be described with reference to FIGS. 5A to 5E.

Referring to FIGS. 5A and 5B, a first substrate 11 having a transparent conductive layer 13 formed thereon is fixed to a jig 10 mounted in a vacuum chamber 100. Subsequently, a first mask M1 having openings respectively corresponding to portions (or the pattern) of an intermediate electrode layer 15 is disposed on the transparent conductive layer 13.

Also, deposition boats 130 are arranged on a ventilator 120 positioned opposite to (or opposing or facing) the jig 110 in the vacuum chamber 100. An intermediate electrode forming material 15a is contained in the deposition boats 130.

The ventilator 120 is operated, and the deposition boats 130 are heated to reach the temperature at which the intermediate electrode forming material 15a can be evaporated. The intermediate electrode forming material 15a evaporated as described above is deposited on the transparent conductive layer 13 through the openings of the first mask M1, thereby forming the intermediate electrode layer 15.

Here, if the intermediate electrode layer 15 has reached a desired thickness, the deposition process of the intermediate electrode layer 15 is stopped. The intermediate electrode layer 15 may be formed to have a thickness desired by a user. However, in one embodiment, the intermediate electrode layer 15 is formed to have a thickness between about 0.01 µm and 10 µm. The intermediate electrode layer 15 may include at least one selected from the group consisting of Ti, Cr, Ni, Nb, Mo, Sn, Ta, W, Pt, Au, sus, ITO, FTO, ZnO, SnO(II), and SnO₂(IV) and/or an alloy including at least two selected from the group consisting of Ti, Cr, Ni, Nb, Mo, Sn, Ta, W, Pt, Au, sus, ITO, FTO, ZnO, SnO(II), and SnO₂(IV).

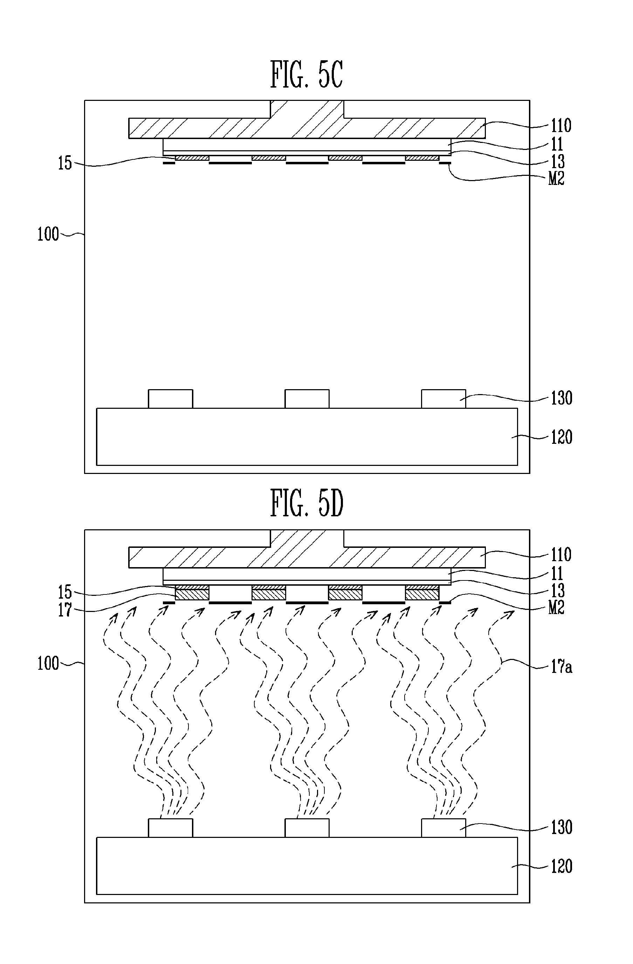

Subsequently, as shown in FIGS. 5C and 5D, a second mask M2 having openings respectively corresponding to (or matching) the pattern (or positions of the portions) of the intermediate electrode layer 15 is disposed on the intermediate electrode layer 15 deposited in the previous process. In this embodiment, the second mask M2 is shown (or labeled) to be different from the first mask M1. However, in another embodiment, the identical first mask M1 is used without the need of the second mask M2 (but moved to provide a set gap between the mask and the intermediate electrode layer 15). Here, in one embodiment, the set gap matches a desired thickness of the metal electrode layer 17.

As described in the previous process, the deposition boats 130 are arranged on the ventilator 120 positioned opposite to the jig 110 in the vacuum chamber 100. However, a metal electrode forming material 17a is contained in the deposition boats 130.

Similarly, the ventilator 120 is operated, and the deposition boats 130 are heated to reach the temperature at which the metal electrode forming material 17a can be evaporated. The metal electrode forming material 17a evaporated as described above is deposited on the intermediate electrode layer 15 through the openings of the second mask M2, thereby forming the metal electrode layer 17.

Here, if the metal electrode layer 17 has reached a desired thickness, the deposition process of the metal electrode layer 17 is stopped. The metal electrode layer 17 may be formed to have a thickness desired by a user. However, in one embodiment, the intermediate electrode layer 15 is formed to have a thickness between about 0.1 µm and 100 µm. The metal electrode layer 17 may include at least one selected from the group consisting of Al, Ni, Cu, Zn, Mo, Ag, Pt, and Au, and/or an alloy including at least two selected from the group consisting of Al, Ni, Cu, Zn, Mo, Ag, Pt, and Au.

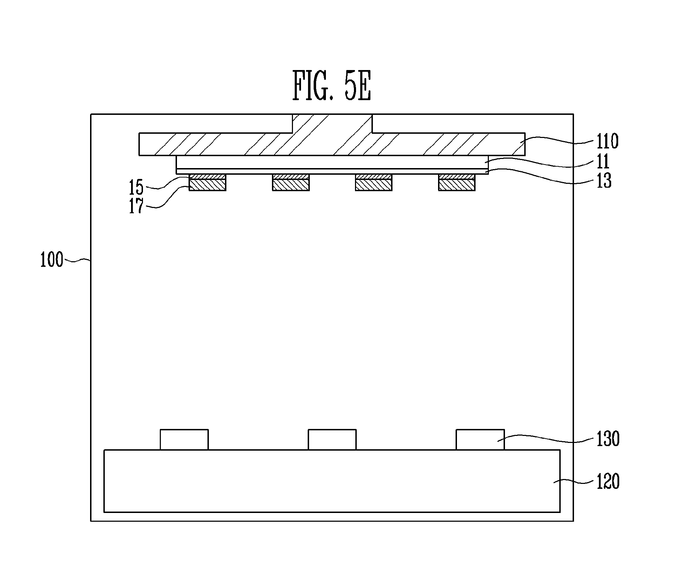

Finally, as shown in FIG. 5E, the second mask M2 disposed on the metal electrode layer 17 is removed, and the first substrate 11 is separated from the jig 110, thereby completing the first electrode 10 for the photoelectric device 1. In the first electrode 10 for the photoelectric device 1, the intermediate electrode layer 15 and the metal electrode layer 17 are continuously deposited and formed on the first substrate 11 so that adhesion is enhanced.

Hereinafter, the processes of preparing the electrode for the photoelectric device according to the second embodiment of the present invention will be described with reference to FIGS. 6A to 6D in more detail.

Referring to FIGS. 6A and 6B, a first substrate 11 having a transparent conductive layer 13 formed thereon is fixed to a jig 10 mounted in a vacuum chamber 100. Subsequently, a mask M1' having an opening (or openings) corresponding or overlapping with the pattern (or portions) of the transparent conductive layer 13 is disposed on the transparent conductive layer 13.

Also, deposition boats 130 are arranged on a ventilator 120 positioned opposite to (or opposing or facing) the jig 110 in the vacuum chamber 100. An intermediate electrode forming material 15a is contained in the deposition boats 130.

The ventilator 120 is operated, and the deposition boats 130 are heated to reach the temperature at which the intermediate electrode forming material 15a can be evaporated. The intermediate electrode forming material 15a evaporated as described above is deposited on the transparent conductive layer 13 through the opening(s) of the mask M1', thereby forming a preliminary intermediate electrode layer 15P.

Here, if an intermediate electrode layer 15 to be formed later has reached a desired thickness, the deposition process of the preliminary intermediate electrode layer 15P is stopped. The preliminary intermediate electrode layer 15P may be formed to have a thickness desired by a user. However, in one embodiment, the preliminary intermediate electrode layer 15P is formed to have a thickness between about 0.01µm and 10 µm. The preliminary intermediate electrode layer 15P may include at least one selected from the group consisting of Ti, Cr, Ni, Nb, Mo, Sn, Ta, W, Pt, Au, sus, ITO, FTO, ZnO, SnO(II), and SnO₂(IV) and/or an alloy including at least two selected from the group consisting of Ti, Cr, Ni, Nb, Mo, Sn, Ta, W, Pt, Au, sus, ITO, FTO, ZnO, SnO(II), and SnO₂(IV).

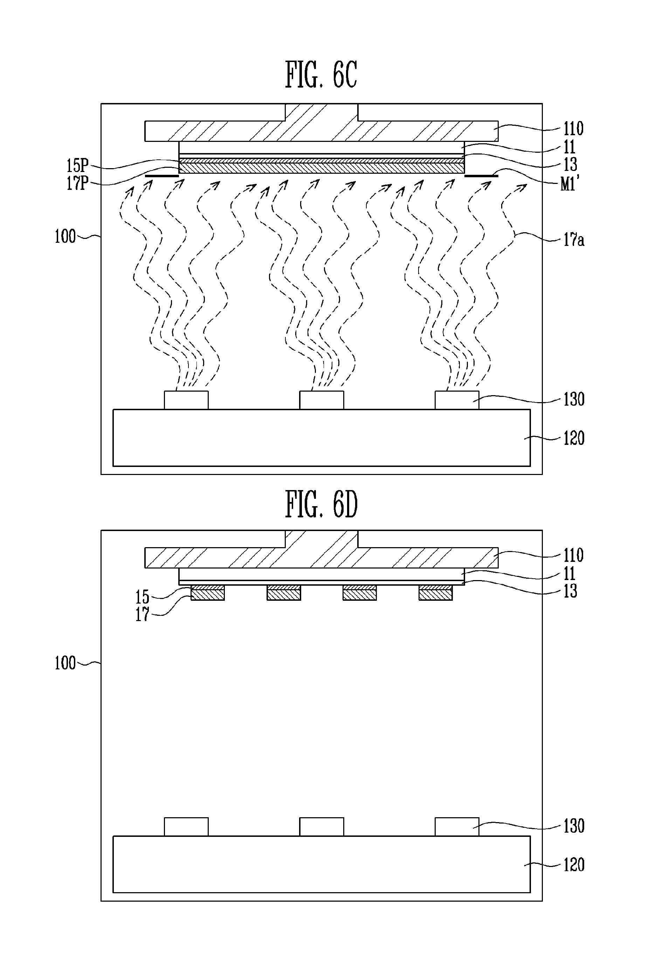

Subsequently, as shown in FIG. 6C, the ventilator 120 is continuously operated, and the deposition boats 130 are heated to reach the temperature at which a metal electrode forming material 17a can be evaporated. The metal electrode forming material 17a evaporated as described above is deposited on the preliminary intermediate electrode layer 15P through the opening(s) of the mask M1', thereby forming a preliminary metal electrode layer 17P.

Subsequently, as shown in FIG. 6D, the mask M1' disposed on the preliminary metal electrode layer 17P is removed, and the first substrate 11 is separated from the jig 110. Finally, the preliminary intermediate electrode layer 15P and the preliminary metal electrode layer 17P are etched, thereby completing the first electrode 10 for the photoelectric device 1. In the first electrode 10 for the photoelectric device 1, the intermediate electrode layer 15 and the metal electrode layer 17 are continuously deposited and formed on the first substrate 11 so that adhesion is enhanced.

As described above, according to the embodiments of the present invention, the price competitiveness of the photoelectric device can be enhanced by replacing a conventional electrode material.

Also, the adhesion between the metal electrode layer and the transparent conductive layer is increased due to the intermediate electrode layer interposed between the transparent conductive layer and the metal electrode layer, so that it is possible to prevent (or protect from) a phenomenon that the electrolyte solution is penetrated into the interface between the transparent conductive layer and the metal electrode layer, and therefore, the metal electrode layer gets loose. Accordingly, it is possible to increase the photoelectric conversion efficiency of the photoelectric device and to enhance the reliability of the photoelectric device.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. An electrode (10, 10') for a photoelectric device, the electrode comprising:
a transparent conductive layer (13) on a substrate (11, 11');
a metal electrode layer (17) patterned on the transparent conductive layer;
and
an intermediate electrode layer (15) interposed between the transparent conductive layer (13) and the metal electrode layer (17) to join the transparent conductive layer and the metal electrode layer.

2. The electrode according to claim 1, wherein the intermediate electrode layer comprises a material selected from the group consisting of Ti, Cr, Ni, Nb, Mo, Sn, Ta, W, Pt, Au, sus, ITO, FTO, ZnO, SnO(II), SnO₂(IV) and combinations thereof.

3. The electrode according to claim 1 or 2, wherein the intermediate electrode layer has a thickness between about 0.01 µm and 10 µm.

4. The electrode according to any one of the preceding claims, wherein the intermediate electrode layer (15) is arranged in a pattern that matches the pattern of the metal electrode layer (17).

5. The electrode according to any one of the preceding claims, wherein the metal electrode layer (17) comprises a material selected from the group consisting of Al, Ni, Cu, Zn, Mo, Ag, Pt, Au and combinations thereof.

6. The electrode according to any one of the preceding claims, wherein the metal electrode layer has a thickness between about 0.1 µm and 100 µm.

7. A method of preparing an electrode for a photoelectric device, the method comprising:
providing a substrate (11, 11') having a transparent conductive layer (13) formed thereon;
forming an intermediate electrode layer (15) on the transparent conductive layer; and
forming a metal electrode layer (17) on the intermediate electrode layer (15) so that the metal electrode layer is joined with the transparent conductive layer (13).

8. The method according to claim 7, wherein forming the intermediate electrode layer comprises:
disposing a first mask having openings respectively matching portions of the transparent conductive layer; and
depositing an intermediate electrode forming material on the transparent conductive layer through the openings.

9. The method according to claim 8, wherein the intermediate electrode forming material comprises a material selected from the group consisting of Ti, Cr, Ni, Nb, Mo, Sn, Ta, W, Pt, Au, sus, ITO, FTO, ZnO, SnO(II), SnO₂(IV) and combinations thereof.

10. The method according to claim 8 or 9, wherein the intermediate electrode forming material is deposited to have a thickness between about 0.01µm and 10µm.

11. The method according to any one of claims 7 to 10, wherein, in the forming of the metal electrode layer, the intermediate electrode layer has a pattern matching the pattern of the metal electrode layer.

12. The method according to any one of claims 7 to 11, wherein forming the metal electrode layer comprises:
disposing a second mask having openings respectively matching portions of the intermediate electrode layer; and
depositing a metal electrode forming material on the intermediate electrode layer through the openings.

13. The method according to claim 12, wherein the metal electrode forming material comprises a material selected from the group consisting of Al, Ni, Cu, Zn, Mo, Ag, Pt, Au and combinations thereof.

14. The method according to claim 12 or 13, wherein the metal electrode forming material is deposited to have a thickness between about 0.1 µm and 100 µm.

15. The method according to claim 7, wherein the forming of the intermediate electrode layer and the metal electrode layer comprises:
depositing an intermediate electrode forming material on the transparent conductive layer, thereby forming a preliminary intermediate electrode layer;
depositing a metal electrode forming material on the intermediate electrode forming material, thereby forming a preliminary metal electrode layer; and
etching the preliminary intermediate electrode layer and the preliminary metal electrode layer.
